# EUROPÄISCHE PATENTSCHRIFT

(11) **EP 3 845 046 B1**
(45) Veröffentlichungstag und Bekanntmachung des Hinweises auf die Patenterteilung: **01.05.2024**
(21) Anmeldenummer: 19755805.9
(22) Anmeldetag: 09.08.2019
(51) Int. Cl.: H05K 7/14

(54) **UMRICHTERANORDNUNG UND VERFAHREN ZUM BETREIBEN EINER UMRICHTERANORDNUNG**
CONVERTER ASSEMBLY AND METHOD FOR OPERATING A CONVERTER ASSEMBLY
ENSEMBLE CONVERTISSEUR ET PROCÉDÉ POUR FAIRE FONCTIONNER UN ENSEMBLE CONVERTISSEUR

(30) Priorität: 27.08.2018 DE 102018006721
(43) Veröffentlichungstag der Anmeldung: 07.07.2021
(73) Patentinhaber: SEW-EURODRIVE GmbH & Co. KG, 76646 Bruchsal (DE)
(72) Erfinder: HOFFMANN, Philipp, 76863 Herxheim (DE); MAYER, Ralph, 76698 Ubstadt-Weiher (DE)
(86) Internationale Anmeldenummer: PCT/EP2019/025263
(87) Internationale Veröffentlichungsnummer: WO 2020/043323

(56) Entgegenhaltungen:
- DE-A1-102009 031 466
- DE-U1- 20 102 038

## Beschreibung

Die Erfindung betrifft eine Umrichteranordnung und ein Verfahren zum Betreiben einer Umrichteranordnung.

Es ist allgemein bekannt Elektromotoren aus Umrichtern zu speisen.

Aus der DE 10 2009 031 466 A1 ist eine Anlage mit Elektromotoren bekannt.

**Aus der** DE 10 2009 031 466 A1 **ist als nächstliegender Stand der Technik ist ein Elektromotor bekannt.**

**Aus der** DE 201 02 038 U1 **ist ein passiver Verteiler zum Verbinden von elektrischen Geräten wie Aktoren und/oder Sensoren bekannt.**

Der Erfindung liegt daher die Aufgabe zugrunde, eine Umrichteranordnung weiterzubilden, wobei eine hohe Varianz von Verwendungsmöglichkeiten mit geringem Aufwand erreichbar sein soll, insbesondere für einen sicheren Betrieb.

Erfindungsgemäß wird die Aufgabe bei der Umrichteranordnung nach den in Anspruch 1 und bei dem Verfahren nach den in Anspruch 11 angegebenen Merkmalen gelöst.

Unter Umrichteranordnung wird in der vorliegenden Schrift nicht nur eine Anordnung verstanden, die einen Umrichter aufweist, sondern auch eine Anordnung, die statt eines Umrichters einen Wechselrichter aufweist.

Wichtige Merkmale der Erfindung bei der Umrichteranordnung sind, dass die Umrichteranordnung ein Anschlussteil und ein darauf aufgesetztes verbundenes, insbesondere in hoher Schutzart verbundenes, Deckelteil aufweist,
wobei das Deckelteil ein erstes Steckverbinderteil zum Anschließen einer Datenbusleitung, insbesondere zum Anschließen eines entsprechenden, an einem Endbereich einer Datenbusleitung konfektionierten Gegensteckverbinderteils, aufweist,
wobei das Anschlussteil zumindest eine Anschlussvorrichtung für zumindest eine Versorgungsleitung, insbesondere Drehstromleitung, aufweist,
wobei im Anschlussteil ein erstes Buchsenteil zum Anschließen einer Datenbusleitung, insbesondere zum Anschließen eines entsprechenden, an einem Endbereich einer Datenbusleitung konfektionierten Steckerteils, angeordnet ist,
wobei die Kontakte des ersten Buchsenteils elektrisch, insbesondere mittels Leiterbahnen, einer Leiterplatte, verbunden sind mit Kontakten eines dritten Steckverbinderteils, welches mit einem entsprechenden Gegensteckverbinderteils in Steckverbindung gebracht ist, so dass die Kontakte elektrisch verbunden sind mit einem ersten Eingang eines Umschalters einer elektronischen Schaltung, welche im Deckelteil angeordnet ist,
wobei die Kontakte des ersten Steckverbinderteils elektrisch verbunden sind mit einem zweiten Eingang des Umschalters,
wobei der Ausgang des Umschalters abhängig vom Schaltzustand des Umrichters elektrisch verbunden ist mit dem ersten Eingang oder mit dem zweiten Eingang,
insbesondere wobei der Ausgang mit einem als Busteilnehmer ausgeführten Teil der elektronischen Schaltung verbunden ist.

Von Vorteil ist dabei, dass zwei verschiedene Anschlussmöglichkeiten ermöglicht werden. Bei der ersten Anschlussmöglichkeit werden Hybridkabel verwendet und die gesamte Anschlusstechnik im Anschlussteil ausgeführt. Hierbei müssen nach Durchführen des Hybridkabels Abisolierarbeiten und Konfektionierarbeiten ausgeführt werden. Das Deckelteil bleibt während dieser Arbeiten entfernt und wird erst zuletzt aufgesetzt und verbunden. Dabei übernimmt der dritte Steckverbinder die elektrische Verbindungstechnik zum Deckelteil. Wenn jedoch die Busleitung am Deckelteil angeschlossen werden soll, ist dies auch ermöglicht und es muss nur eine Verschlusskappe entfernt und ein Stecker in ein Buchsenteil eingesteckt werden. Somit ist trotzdem eine hohe Schutzart beibehaltbar. Die aufwendige Anschlusstechnik für die Leistungsverdrahtung wird aber trotzdem zunächst im Anschlussteil ausgeführt und danach das Deckelteil aufgesetzt. Das Verbinden mit der Datenbusleitung erfordert dann nur das Einstecken der Steckverbinder in die Buchsenteile des Deckelteils. Dies erfordert aber nur einen geringen Aufwand. Somit ist mit geringem Aufwand eine hohe Varianz an Verwendungsmöglichkeiten erreicht.

Weiter ist von Vorteil, dass mittels des Umschalters ein nicht benötigter Leitungsabschnitt abtrennbar und/oder abschaltbar ist, welcher innerhalb des Gehäuses der Umrichteranordnung angeordnet ist. Somit ist Abstrahlung von störenden Signalbeiträgen verringerbar. Störstrahlung ist also von der elektronischen Schaltung fernhaltbar. Daher ist ein sicherer Betrieb ermöglicht.

Erfindungsgemäß ist im Deckelteil ein T-Knoten für die Datenbusleitung vorhanden,
wobei im Anschlussteil ein T-Knoten für die Versorgungsleitung, insbesondere Drehstromleitung, vorhanden ist und ebenfalls ein T-Knoten für eine Datenbusleitung vorhanden ist,
wobei mittels des Umschalters entweder der T-Knoten des Deckelteils oder der T-Knoten für Datenbusleitung des Anschlussteils elektrisch mit dem als Busteilnehmer ausgeführten Teil der elektronischen Schaltung verbunden ist. Von Vorteil ist dabei, dass zwar ein ungenutzter T-Knoten vorhanden ist, aber das Auswählen der Datenbuszuleitung durch das Anschlussteil oder Deckelteil ermöglicht ist. Mittels des Umschalters sind dann ungenutzte Leitungsabschnitte abschaltbar.

Bei einer vorteilhaften Ausgestaltung weist das Deckelteil ein zweites Steckverbinderteil zum Anschließen einer weiteren Datenbusleitung, insbesondere zum Anschließen eines entsprechenden, an einem Endbereich einer weiteren Datenbusleitung konfektionierten weiteren Gegensteckverbinderteils, auf,
wobei die Kontakte des ersten Steckverbinderteils mit den Kontakten des zweiten Steckverbinderteils elektrisch verbunden sind. Von Vorteil ist dabei, dass die Datenbusleitung durchschleifbar ist und gleichzeitig ein Abzweig über das dritte Steckverbinderteil zum Deckelteil hin für die Zuführung von Datensignalen an die elektronische Schaltung erreichbar ist.

Bei einer vorteilhaften Ausgestaltung sind die Drehstromleitung und die Datenbusleitung der Umrichteranordnung als Hybridkabel oder separat zugeführt. Von Vorteil ist dabei, dass entweder ein Hybridkabel durch das Anschlussteil führbar ist und somit eine einfache Zuführung von Information und Leistung erreichbar ist. Das Deckelteil kann somit ohne großen Aufwand ausgetauscht werden.

Bei einer vorteilhaften Ausgestaltung ist zur Speisung der elektronischen Schaltung ein jeweiliges Kontaktteil der Anschlussvorrichtung mit zwei oder mehr Kontaktteilen des dritten Steckverbinderteils elektrisch verbunden, insbesondere sodass über mehrere Kontakte des entsprechenden Gegensteckverbinderteils des Deckelteils die elektronische Schaltung gespeist ist. Von Vorteil ist dabei, dass die aus dem dritten Steckverbinderteil und dem entsprechenden Gegensteckverbinderteil gebildete Übergabesteckverbindung mehrere Kontakte parallel zur Verfügung stellen kann, damit hohe Leistungen mittels des Steckverbinders ans Deckelteil übertragbar sind. Ebenso wird dem Elektromotor Strom vom Deckelteil aus zugeführt, indem andere Kontakte des Steckverbinders parallelgeschaltet werden.

Bei einer vorteilhaften Ausgestaltung weist das Anschlussteil ein zweites Buchsenteil zum Anschließen einer weiteren Datenbusleitung auf,
wobei die Kontakte des ersten Buchsenteils mit den Kontakten des zweiten Buchsenteils elektrisch verbunden sind. Von Vorteil ist dabei, dass die Datenbusleitung durchschleifbar ist und somit weitere Busteilnehmer anbindbar sind. Somit ist also ein T-Knoten in der Umrichteranordnung realisiert.

Bei einer vorteilhaften Ausgestaltung weist das Anschlussteil eine weitere Anschlussvorrichtung für eine weitere Drehstromleitung auf, wobei die Kontakte der weiteren Anschlussvorrichtung mit den Kontakten der ersten Anschlussvorrichtung elektrisch verbunden sind. Von Vorteil ist dabei, dass die Drehstromleitung durchschleifbar ist und somit weitere Verbraucher seriell versorgbar sind.

Bei einer vorteilhaften Ausgestaltung sind das erste und das zweite Buchsenteil mit einer Verschlusskappe dicht, also in hoher Schutzart, verschlossen. Von Vorteil ist dabei, dass im Auslieferzustand die Umrichteranordnung in hoher Schutzart ausführbar ist. Die Verschlusskappen sind somit so lange zum Abdichten verwendbar, bis ein Stecker mit dem Buchsenteil verbunden werden soll, so dass auch dann eine hohe Schutzart gewährleistbar sind.

Wichtige Merkmale bei dem Verfahren sind, dass in einem ersten Verfahrensschritt, insbesondere zu Beginn des Betriebs der Umrichteranordnung, der Umschalter so lange abwechselnd im ersten oder zweiten Schaltzustand betrieben wird, bis in einem der beiden Schaltzustände ein Bussignal erkannt wird, insbesondere eine, insbesondere als Broadcasttelegramm von einem Busmaster gesendete, Bitfolge,
danach in einem zweiten Verfahrensschritt, insbesondere zum Dauerbetrieb der Umrichteranordnung, der Umschalter dauerhaft in demjenigen Schaltzustand gehalten wird, bei dem die Bitfolge erkannt wurde.

Von Vorteil ist dabei, dass erkennbar ist, ob die Datenbusleitung am Deckelteil angeschlossen ist oder in einem Hybridkabel ins Anschlussteil eingeführt und angeschlossen ist. Die jeweils nicht verwendeten Leitungsabschnitte werden dann mittels des Umschalters abgetrennt, so dass Störstrahlung verhinderbar oder zumindest verminderbar ist.

Bei einer vorteilhaften Ausgestaltung wird zur Erkennung des Bussignals das Maximum einer diskreten Faltung bezüglich eines Parameters bestimmt wird,
welche als diskrete Faltung einer über den Datenbus empfangenen, insbesondere erfassten, Bitfolge und einer bekannten, insbesondere also in einem Speicher hinterlegten, um den Parameter verschobenen Bitfolge gebildet wird. Von Vorteil ist dabei, dass der Parameter als zeitlicher Versatz zwischen den beiden Bitfolgen verwendet wird und durch Bestimmen der diskreten Faltung für verschiedene Parameter das Maximum bezüglich des Parameters auffindbar ist.

Somit ist dann der zum Maximum gehörige Parameter zur zeitlichen Synchronisierung verwendbar. Vorzugswiese wird aber nur dann der zum Maximum gehörige Parameter zur zeitlichen Synchronisation verwendet, wenn das Maximum einen vorgegebenen Schwellwert überschreitet.

Bei einer vorteilhaften Ausgestaltung wird zur Erkennung des Bussignals das Maximum einer Summe in Abhängigkeit von einem Parameter bestimmt und wird mit einem Schwellwert verglichen,
wobei die Summe als Summe der Produkte aus einer erfassten Bitfolge und einer bekannten, insbesondere also in einem Speicher hinterlegten, um den Parameter verschobenen Bitfolge gebildet wird. Von Vorteil ist dabei, dass eine einfache Kreuzkorrelation bestimmt wird und dabei mittels des für das Maximum gültigen Parameters sogar ein Zeitversatz zwischen der Zeitbasis des Busmasters und der Zeitbasis der Umrichteranordnung, insbesondere der elektronischen Schaltung des Deckelteils, bestimmbar ist und somit eine Aufsynchronisation ermöglicht ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von schematischen Abbildungen näher erläutert:
In der Figur 1 ist eine erfindungsgemäße Umrichteranordnung, aufweisend ein Deckelteil 1 und ein Anschlussteil 2, in Schrägansicht dargestellt.

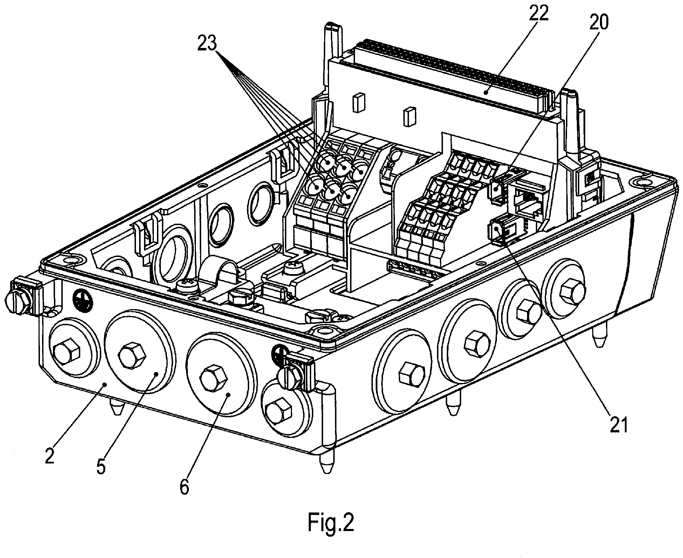

In der Figur 2 ist eine Schrägansicht des Anschlussteils 2 dargestellt, insbesondere bei entferntem Deckelteil 1.

Wie in den Figuren dargestellt, weist die erfindungsgemäße Umrichteranordnung das Anschlussteil 2 und das darauf aufgesetzte und verbundene Deckelteil 1 auf.

Dabei weist das Anschlussteil ein drittes Steckverbinderteil 22 auf, welches mit einem entsprechenden Gegensteckverbinderteil des Deckelteils 1 steckverbunden ist

Das Anschlussteil 2 weist eine erste Kabelverschraubung 5 auf, durch welche ein Drehstromkabel in den Innenraum des Anschlussteils 2 in hoher Schutzart hereinführbar ist. Die Leitungen des Drehstromkabels werden im Anschlussteil 2 zu Anschlussvorrichtungen 23 geführt und dort elektrisch kontaktiert und verbunden mit jeweiligen leitfähigen Kontaktteilen, welche elektrisch verbunden sind mit Kontaktteilen weiterer Anschlussvorrichtungen 23, mit welchen die Leitungen eines weiteren Drehstromkabels elektrisch kontaktiert und verbunden sind, dass durch die zweite Kabelverschraubung 6 in hoher Schutzart in die Umgebung herausgeführt ist.

Darüber hinaus sind die Kontaktteile aber auch elektrisch jeweils verbunden mit Kontakten des dritten Steckverbinderteils 22, so dass die Drehstromversorgung über das Gegensteckverbinderteil dem Deckelteil 1 zur Verfügung stellbar sind.

Auf diese Weise ist also ein T-Knoten für die Leistungsversorgung im Anschlussteil 1 ausgeführt. Weitere Geräte sind mit dem aus der zweiten Kabelverschraubung 6 herausgeführten weiteren Drehstromkabel versorgbar.

Durch Parallelschaltung mehrerer Kontakte des Steckverbinderteils 22 sind starke Ströme dem Deckelteil 2 zuführbar.

Entsprechend ist eine Datenbusleitung mit an ihrem ersten Endbereich angeordneten, insbesondere konfektionierten, Stecker in ein erstes Steckverbinderteil 3, insbesondere Buchse, einsteckbar und elektrisch verbindbar. Dabei ist das erste Steckverbinderteil 3 in der Wandung des Gehäuses des Deckelteils 1 angeordnet und in hoher Schutzart verbunden. Die Kontakte des ersten Steckverbinderteils 3 sind insbesondere auch über Leiterbahnen einer mittels einer ersten Leiterplatte des Deckelteils 1 einem Auswahlmittel mit Umschalter zugeführt.

Über den Umschalter sind die Signale der Datenbusleitung einer als Busteilnehmer ausgeführten elektronischen Schaltung abhängig vom angesteuerten Schaltzustand des Umschalters zuführbar oder nicht.

Außerdem ist auch im Deckelteil 1 ein T-Knoten für die Datenbusleitung ausgeführt, so dass die Datenbusleitung auch vom ersten Steckverbinderteil 3 zu einem zweiten Steckverbinderteil 2 geführt ist, insbesondere ebenfalls Buchse. Eine weitere Datenbusleitung ist somit mit an ihrem ersten Ende angeordneten, insbesondere konfektionierten, Stecker in das zweite Steckverbinderteil 4, insbesondere Buchse, einsteckbar und elektrisch verbindbar. Dabei ist auch das zweite Steckverbinderteil 4 in der Wandung des Gehäuses des Deckelteils 1 angeordnet und in hoher Schutzart verbunden. Somit sind die Kontakte des zweiten Steckverbinderteils 4 elektrisch auch mit dem Auswahlmittel mit Umschalter verbunden.

Somit muss also die Leistung, insbesondere Versorgungsleistung, über das Drehstromkabel ans Anschlussteil 2 zugeführt werden und die Information über die separate Datenbusleitung an das Deckelteil 1.

Anstatt dieser zwei separaten Kabel sind Leistung und Information auch über ein Hybridkabel durch die erste Kabelverschraubung 5 an das Anschlussteil 2 zuführbar.

Bei dieser unterschiedlichen Ausführung werden wiederum Anschlussteil und Deckelteil verwendet, allerdings wird eine jeweils andersartige unterschiedliche Anschlussverdrahtung ausgeführt.

Erst im Innenraum des Anschlussteils 2 werden dann Drehstromleitungen und Datenbusleitung separiert, die Datenbusleitung an ihrem Endbereich mit einem Steckverbinderteil konfektioniert und mit diesem konfektionierten Steckverbinderteil in das erste Buchsenteil 20 eingesteckt.

Die Drehstromleitungen werden wiederum im Anschlussteil 2 zu Anschlussvorrichtungen 23 geführt und dort elektrisch kontaktiert und verbunden mit jeweiligen leitfähigen Kontaktteilen, welche elektrisch verbunden sind mit Kontaktteilen weiterer Anschlussvorrichtungen 23, mit welchen die Drehstromleitungen eines weiteren Hybridkabels elektrisch kontaktiert und verbunden sind, dass durch die zweite Kabelverschraubung 6 in hoher Schutzart in die Umgebung herausgeführt ist.

Ebenso ist die Datenbusleitung des weiteren Hybridkabels an ihrem Endbereich mit einem Steckverbinderteil konfektioniert und mit diesem konfektionierten Steckverbinderteil in das zweite Buchsenteil 21 eingesteckt.

Die Kontakte der Buchsenteile 20 und 21 sind elektrisch miteinander verbunden und mit zumindest einem Kontakt des dritten Steckverbinderteils 22. Somit ist ein T-Knoten auch für die Datenbusleitung gebildet.

Die Leitungen des Hybridkabels sind somit durch den Anschlussteil 2 durchgeschleift und die elektronische Schaltung im Deckelteil 1 ist mit Leistung und Information versorgt.

Somit ist also die Umrichteranordnung in erster Ausführung mit separatem Drehstromkabel und separater Datenbusleitung oder alternativ in zweiter Ausführung mit Hybridkabel versorgbar.

Bei der ersten Ausführung wird die Datenbusleitung dem Deckelteil 1 zugeführt, wobei ein unterschiedliches Steckverbinderteil verwendet wird als bei der Zuführung der Datenbusleitung ans Anschlussteil gemäß der zweiten Ausführung.

Denn bei der ersten Ausführung ist das Steckverbinderteil an der Außenseite des Deckelteils in ein Buchsenteil 3 beziehungsweise 4 eingesteckt, wofür eine hohe Schutzart notwendig ist.

Bei den Buchsenteilen 20 und 21 des Anschlussteils 2 muss keine hohe Schutzart eingehalten werden. Daher ist hierbei eine andere Art von Steckverbinderteilen und Buchsenteilen (20, 21) verwendbar.

Bei der zweiten Ausführung, also Verkabelung mittels Hybridkabeln, werden also nur Anschlüsse im Anschlussteil verwendet, nicht aber im Deckelteil.

Der Umschalter ermöglicht eine Zuführung der Datensignale der Datenbusleitung an die elektronische Schaltung, wobei seine erste Schalterstellung für den Betrieb bei der ersten Ausführung und seine andere Schalterstellung für den Betrieb bei der zweiten Ausführung vorgesehen ist.

In der ersten Schalterstellung wird also die von den Buchsenteilen 3 und 4 hergeführte Datenbusleitung durchgeleitet und die über das dritte Steckverbinderteil 22 von den Buchsenteilen 20 und 21 hergeführte Datenbusleitung abgetrennt.

Entsprechend wird in der zweiten Schalterstellung die über das dritte Steckverbinderteil 22 von den Buchsenteilen 20 und 21 hergeführte Datenbusleitung über den Umschalter an die elektronische Schaltung weitergeleitet und die von den Buchsenteilen 3 und 4 hergeführte Datenbusleitung des Deckelteils 1 abgetrennt.

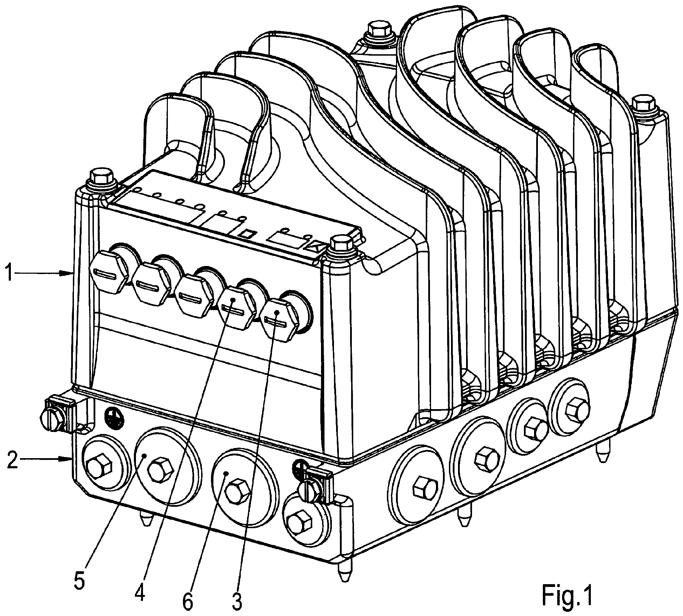

In Figur 1 sind die Buchsenteile 3 und 4 zur Einhaltung einer hohen Schutzart mit Verschlusskappen geschützt verschlossen. Bei der ersten Ausführung werden diese Verschlusskappen entfernt und bei der zweiten Ausführung belassen.

Ebenso sind die Kabelverschraubungen bei Auslieferung in hoher Schutzart ausgeführt, so dass die Umrichteranordnung geschützt ist. Bei Durchführung der Kabel ist ebenfalls hohe Schutzart erreicht.

Die elektronische Schaltung weist einen Umrichter auf, der einen aus den Drehstromleitungen gespeisten Gleichrichter aufweist und einen mit seinem gleichspannungsseitigen Anschluss mit dem gleichspannungsseitigen Anschluss des Gleichrichters verbundenen Wechselrichter, welcher einem Elektromotor ein Drehspannungssystem zur Verfügung stelle. Die Signalelektronik erzeugt Ansteuersignale für steuerbare Halbleiterschalter des Wechselrichters, wobei das Ansteuersignal in Abhängigkeit von den über die Datenbusleitungen erhaltenen Informationen erzeugt werden.

Bei Inbetriebnahme der Umrichteranordnung wird zunächst geprüft, ob die Datenbusleitung über das Anschlussteil 2, also Buchsenteile 20 oder 21, erfolgt oder über das Anschließen einer Datenbusleitung am Deckelteil 1.

Hierzu wird der Umschalter bei Inbetriebnahme der Umrichteranordnung zwischen seinen beiden Schaltzuständen so oft hin- und her geschaltet, bis in einem der Schaltzustände ein Datenstrom eindeutig erkennbar ist. dabei verbleibt der Umschalter in jedem der Schaltzustände jeweils eine Mindestzeitspanne.

Der Busmaster sendet anfangs zeitlich wiederkehrend Broadcasttelegramme, deren Bitfolge auch der elektronischen Schaltung bekannt sind, also in einem Speicher hinterlegt ist. Sobald in einem der Schaltzustände diese Bitfolge besser erkannt wird als im anderen Schaltzustand, wird der bessere der beiden dauerhaft gehalten, also im nachfolgenden regulären Betrieb unverändert belassen.

Vorzugsweise wird zum Erkennen die Summe der erkannten Bits des von der Datenbusleitung gelieferten Signals innerhalb der Zeitdauer der Bitfolge gebildet und mit einem oder mehreren Schwellwerten verglichen. Alternativ wird die Korrelation zwischen der erfassten und bekannten Bitfolge gebildet und ausgewertet. Insbesondere wird die Summe der in der Zeitdauer der Bitfolge der erfassten Bitfolge und bekannten, um einen Parameter verschobenen Bitfolge gebildet, und das Maximum der Summe in Abhängigkeit vom Parameter gebildet. Wenn dieses Maximum einen Schwellwert überschreitet, wird der Umschalter in dem zu diesem Maximum zugehörigen Schaltzustand dauerhaft gehalten.

Zur Auswertung einer Korrelation ist eine diskrete Faltung anwendbar, wobei der Parameter die Verschiebung der empfangenen zur gespeicherten Bitfolge darstellt. Durch Bestimmen des Maximums der diskreten Faltung bezüglich des Parameters ist der zum Maximum gehörige Parameter bestimmbar. Durch Vergleich des Maximums mit einem Schwellwert sind Störungen unterdrückbar. Außerdem ist der Parameter als zeitlicher Versatz und somit zur zeitlichen Synchronisierung verwendbar.

Mit dem Anschlussteil 2 ist die Umrichteranordnung entweder in einem Schaltschrank anordenbar oder dezentral in einer Anlage, wobei auch die Unterseite des Anschlussteils 2 in hoher Schutzart ausgeführt ist - ebenso wie das Deckelteil 1. Bei weiteren erfindungsgemäßen Ausführungsbeispielen wird das Anschlussteil auf einem Klemmenkastenansatz, also Anschlusskastenansatz, des Gehäuses eines von der elektronischen Schaltung gespeisten Elektromotors angeordnet. Hierzu wird das Gehäuse in hoher Schutzart mit dem Anschlussteil verbunden, wobei aber die Statorwicklungsdrähte des Elektromotors durch eine Öffnung der Unterseite des Anschlussteils zu Anschlussvorrichtungen des Anschlussteils geführt sind, die elektrisch über das dritte Steckverbinderteil mit dem wechselspannungsseitigen Anschluss des Wechselrichters der elektronischen Schaltung der Umrichteranordnung verbunden sind.

### Bezugszeichenliste

1 Deckelteil
2 Anschlussteil
3 erstes Steckverbinderteil
4 zweiten Steckverbinderteil
5 erste Kabelverschraubung
6 zweite Kabelverschraubung
20 erstes Buchsenteil
21 zweites Buchsenteil
22 drittes Steckverbinderteil
23 Anschlussvorrichtung

## Patentansprüche

1. Umrichteranordnung,
aufweisend ein Anschlussteil (2) und ein darauf aufgesetztes verbundenes, insbesondere in hoher Schutzart verbundenes, Deckelteil (1),
wobei das Deckelteil ein erstes Steckverbinderteil (3) zum Anschließen einer Datenbusleitung, insbesondere zum Anschließen eines entsprechenden, an einem Endbereich einer Datenbusleitung konfektionierten Gegensteckverbinderteils (20), aufweist,
wobei das Anschlussteil zumindest eine Anschlussvorrichtung für zumindest eine Versorgungsleitung, insbesondere Drehstromleitung, aufweist,
wobei im Anschlussteil ein erstes Buchsenteil zum Anschließen einer Datenbusleitung, insbesondere zum Anschließen eines entsprechenden, an einem Endbereich einer Datenbusleitung konfektionierten Steckerteils, angeordnet ist,
wobei die Kontakte des ersten Buchsenteils elektrisch, insbesondere mittels Leiterbahnen, einer Leiterplatte, verbunden sind mit Kontakten eines dritten Steckverbinderteils (22), welches mit einem entsprechenden Gegensteckverbinderteils in Steckverbindung gebracht ist, so dass die Kontakte elektrisch verbunden sind mit einem ersten Eingang eines Umschalters einer elektronischen Schaltung, welche im Deckelteil angeordnet ist,
wobei die Kontakte des ersten Steckverbinderteils (3) elektrisch verbunden sind mit einem zweiten Eingang des Umschalters,
wobei der Ausgang des Umschalters abhängig vom Schaltzustand des Umrichters elektrisch verbunden ist mit dem ersten Eingang oder mit dem zweiten Eingang,
insbesondere wobei der Ausgang mit einem als Busteilnehmer ausgeführten Teil der elektronischen Schaltung verbunden ist,
**wobei im Deckelteil ein T-Knoten für die Datenbusleitung vorhanden ist,**
**wobei im Anschlussteil ein T-Knoten für die Versorgungsleitung, insbesondere Drehstromleitung, vorhanden ist und ebenfalls ein T-Knoten für eine Datenbusleitung vorhanden ist,**
**wobei mittels des Umschalters entweder der T-Knoten des Deckelteils oder der T-Knoten für Datenbusleitung des Anschlussteils elektrisch mit dem als Busteilnehmer ausgeführten Teil der elektronischen Schaltung verbunden ist.**

2. Umrichteranordnung nach Anspruch 1,
**dadurch gekennzeichnet, dass**
das Deckelteil ein zweites Steckverbinderteil zum Anschließen einer weiteren Datenbusleitung, insbesondere zum Anschließen eines entsprechenden, an einem Endbereich einer weiteren Datenbusleitung konfektionierten weiteren Gegensteckverbinderteils, aufweist,
wobei die Kontakte des ersten Steckverbinderteils mit den Kontakten des zweiten Steckverbinderteils elektrisch verbunden sind.

3. Umrichteranordnung nach mindestens einem der vorangegangenen Ansprüche,
**dadurch gekennzeichnet, dass**
die Drehstromleitung und die Datenbusleitung der Umrichteranordnung als Hybridkabel oder separat zugeführt sind.

4. Umrichteranordnung nach mindestens einem der vorangegangenen Ansprüche,
**dadurch gekennzeichnet, dass**
zur Speisung der elektronischen Schaltung ein jeweiliges Kontaktteil der Anschlussvorrichtung mit zwei oder mehr Kontaktteilen des dritten Steckverbinderteils elektrisch verbunden ist, insbesondere sodass über mehrere Kontakte des entsprechenden Gegensteckverbinderteils des Deckelteils die elektronische Schaltung gespeist ist.

5. Umrichteranordnung nach mindestens einem der vorangegangenen Ansprüche,
**dadurch gekennzeichnet, dass**
das Anschlussteil ein zweites Buchsenteil zum Anschließen einer weiteren Datenbusleitung aufweist,
wobei die Kontakte des ersten Buchsenteils mit den Kontakten des zweiten Buchsenteils elektrisch verbunden sind.

6. Umrichteranordnung nach mindestens einem der vorangegangenen Ansprüche,
**dadurch gekennzeichnet, dass**
das Anschlussteil eine weitere Anschlussvorrichtung für eine weitere Drehstromleitung aufweist, wobei die Kontakte der weiteren Anschlussvorrichtung mit den Kontakten der ersten Anschlussvorrichtung elektrisch verbunden sind.

7. Umrichteranordnung nach mindestens einem der vorangegangenen Ansprüche,
**dadurch gekennzeichnet, dass**
das erste und das zweite Buchsenteil mit einer Verschlusskappe dicht, also in hoher Schutzart, verschlossen sind.

8. Umrichteranordnung nach mindestens einem der vorangegangenen Ansprüche,
**dadurch gekennzeichnet, dass**
im Deckelteil, insbesondere in der elektronischen Schaltung des Deckelteils, ein Mittel zur Bestimmung einer diskreten Faltung aus einer empfangenen Bitfolge und aus einer in einem Speicher des Deckelteils hinterlegten Bitfolge angeordnet ist.

9. Umrichteranordnung nach mindestens einem der vorangegangenen Ansprüche,
**dadurch gekennzeichnet, dass**
ein Auswahlmittel im Deckelteil angeordnet ist und das Ansteuersignal für den Umschalter erzeugt, insbesondere in Abhängigkeit des Erkennens einer empfangenen Bitfolge,
insbesondere wobei das Auswahlmittel den Umschalter im wechselbetrieb hält, solange die Bitfolge nicht erkannt ist, und den Umschalter im Dauerbetrieb hält, nachdem die Bitfolge erkannt ist,
insbesondere wobei das Auswahlmittel das ein Mittel zur Bestimmung einer diskreten Faltung aufweist.

10. Umrichteranordnung nach mindestens einem der vorangegangenen Ansprüche,
**dadurch gekennzeichnet, dass**
das Auswahlmittel, insbesondere in Abhängigkeit des Erkennens einer empfangenen Bitfolge, ein Signal zur zeitlichen Synchronisation bestimmt und/oder erzeugt.

11. Verfahren zum Betreiben einer Umrichteranordnung nach mindestens einem der vorangegangenen Ansprüche,
**dadurch gekennzeichnet, dass**
in einem ersten Verfahrensschritt, insbesondere zu Beginn des Betriebs der Umrichteranordnung, der Umschalter so lange abwechselnd im ersten oder zweiten Schaltzustand betrieben wird, bis in einem der beiden Schaltzustände ein Bussignal erkannt wird, insbesondere eine, insbesondere als Broadcasttelegramm von einem Busmaster gesendete, Bitfolge,
danach in einem zweiten Verfahrensschritt, insbesondere zum Dauerbetrieb der Umrichteranordnung, der Umschalter dauerhaft in demjenigen Schaltzustand gehalten wird, bei dem die Bitfolge erkannt wurde.

12. Verfahren nach Anspruch 11,
**dadurch gekennzeichnet, dass**
zur Erkennung des Bussignals
das Maximum einer diskreten Faltung bezüglich eines Parameters bestimmt wird,
welche als diskrete Faltung einer empfangenen, insbesondere erfassten, Bitfolge und einer bekannten, insbesondere also in einem Speicher hinterlegten, um den Parameter verschobenen Bitfolge gebildet wird.

13. Verfahren nach Anspruch 12,
**dadurch gekennzeichnet, dass**
der zum Maximum gehörige Parameter zur zeitlichen Synchronisierung verwendet wird.

14. Verfahren nach Anspruch 13 oder 12,
**dadurch gekennzeichnet, dass**
nur dann der zum Maximum gehörige Parameter zur zeitlichen Synchronisation verwendet wird, wenn das Maximum einen vorgegebenen Schwellwert überschreitet.

## Claims

1. Converter assembly
comprising a connection part (2) and a connected cover part (1) mounted thereon, in particular a cover part connected with a high protection rating,
wherein the cover part has a first plug-in connector part (3) for connecting a data bus line, in particular for connecting a corresponding mating plug-in connector part (20) assembled on an end region of a data bus line,
wherein the connection part has at least one connection device for at least one supply line, in particular a three-phase line,
wherein a first female connector part for connecting a data bus line, in particular for connecting a corresponding male connector part assembled on an end region of a data bus line, is arranged in the connection part,
wherein the contacts of the first female connector part are electrically connected, in particular by means of conducting tracks of a printed circuit board, to contacts of a third plug-in connector part (22) that is plug-connected to a corresponding mating plug-in connector part such that the contacts are electrically connected to a first input of a changeover switch of an electronic circuit arranged in the cover part,
wherein the contacts of the first plug-in connector part (3) are electrically connected to a second input of the changeover switch,
wherein the output of the changeover switch is electrically connected to either the first input or the second input depending on the switching state of the converter,
in particular wherein the output is connected to a part of the electronic circuit that is configured as a bus subscriber,
wherein a T-node for the data bus line is present in the cover part,
wherein a T-node for the supply line, in particular the three-phase line, is present in the connection part, as is a T-node for a data bus line,
wherein, by means of the changeover switch, either the T-node of the cover part or the T-node for the data bus line of the connection part is electrically connected to the part of the electronic circuit configured as the bus subscriber.

2. Converter assembly according to claim 1,
**characterised in that**
the cover part has a second plug-in connector part for connecting a further data bus line, in particular for connecting a corresponding further mating plug-in connector part assembled on an end region of a further data bus line,
the contacts of the first plug-in connector part being electrically connected to the contacts of the second plug-in connector part.

3. Converter assembly according to at least one of the preceding claims,
**characterised in that**
the three-phase line and the data bus line of the converter assembly are supplied either as a hybrid cable or separately.

4. Converter assembly according to at least one of the preceding claims,
**characterised in that**
to feed the electronic circuit, a relevant contact part of the connection device is electrically connected to two or more contact parts of the third plug-in connector part, in particular such that the electronic circuit is fed via a plurality of contacts of the corresponding mating plug-in connector part of the cover part.

5. Converter assembly according to at least one of the preceding claims,
**characterised in that**
the connection part has a second female connector part for connecting a further data bus line,
the contacts of the first female connector part being electrically connected to the contacts of the second female connector part.

6. Converter assembly according to at least one of the preceding claims,
**characterised in that**
the connection part has a further connection device for a further three-phase line, the contacts of the further connection device being electrically connected to the contacts of the first connection device.

7. Converter assembly according to at least one of the preceding claims,
**characterised in that**
the first and second female connector parts are sealed by a sealing cap in a tight manner, i.e. with a high protection rating.

8. Converter assembly according to at least one of the preceding claims,
**characterised in that**
a means for determining a discrete convolution of a received bit sequence and a bit sequence stored in a memory of the cover part is arranged in the cover part, in particular in the electronic circuit of the cover part.

9. Converter assembly according to at least one of the preceding claims,
**characterised in that**
a selection means is arranged in the cover part and generates the actuation signal for the changeover switch, in particular on the basis of whether a received bit sequence is detected, the selection means in particular keeping the changeover switch in alternating mode as long as the bit sequence is not detected and keeping the changeover switch in continuous mode once the bit sequence is detected,
the selection means in particular having a means for determining a discrete convolution.

10. Converter assembly according to at least one of the preceding claims,
**characterised in that**
the selection means determines and/or generates a time synchronisation signal, in particular on the basis of whether a received bit sequence is detected.

11. Method for operating a converter assembly according to at least one of the preceding claims,
**characterised in that**
in a first method step, in particular at the beginning of the operation of the converter assembly, the changeover switch is operated alternately in the first or second switching state until a bus signal, in particular a bit sequence emitted by a bus master, in particular as a broadcast telegram, is detected in one of the two switching states,
then, in a second method step, in particular for the purpose of the continuous operation of the converter assembly, the changeover switch is kept constantly in the switching state in which the bit sequence was detected.

12. Method according to claim 11,
**characterised in that**
to detect the bus signal, the maximum of a discrete convolution is determined in relation to a parameter,
which discrete convolution is generated as a discrete convolution of a received, in particular acquired, bit sequence and a bit sequence that is known, i.e. in particular stored in a memory, and has been shifted by the parameter.

13. Method according to claim 12,
**characterised in that**
the parameter associated with the maximum is used for time synchronisation.

14. Method according to claim 13 or claim 12,
**characterised in that**
the parameter associated with the maximum is used for time synchronisation only when the maximum exceeds a predetermined threshold.

## Revendications

1. Agencement de convertisseur
comprenant une partie de connexion (2)
et une partie de recouvrement (1) mise en place sur cette dernière et reliée, notamment reliée avec un mode de protection élevé,
ladite partie de recouvrement comportant une première pièce (3) de connexion enfichable, dévolue au raccordement d'une ligne de bus de données,
en particulier au raccordement d'une pièce correspondante (20) de connexion enfichable complémentaire, façonnée au niveau d'une région extrême d'une ligne de bus de données, ladite partie de connexion étant pourvue d'au moins un dispositif de raccordement affecté à au moins une ligne d'alimentation, notamment à une ligne de courant triphasé,
sachant qu'une première pièce formant douille est intégrée dans ladite partie de connexion en vue du raccordement d'une ligne de bus de données,
notamment du raccordement d'une pièce correspondante formant fiche, façonnée au niveau d'une région extrême d'une ligne de bus de données,
sachant que les contacts de ladite première pièce formant douille sont connectés électriquement, en particulier au moyen de pistes conductrices d'une plaquette à circuits imprimés, à des contacts d'une troisième pièce (22) de connexion enfichable
qui est mise en liaison, par enfichage, avec une pièce correspondante de connexion enfichable complémentaire, de façon telle que lesdits contacts soient connectés électriquement à une première entrée d'un commutateur d'un circuit électronique intégré dans la partie de recouvrement,
les contacts de la première pièce (3) de connexion enfichable étant raccordés électriquement à une seconde entrée du commutateur,
la sortie dudit commutateur étant connectée électriquement à la première entrée ou à la seconde entrée, en fonction de l'état de commutation du convertisseur,
sachant notamment que la sortie est connectée à une partie dudit circuit électronique conçue en tant qu'abonné au bus,
un point nodal T, assigné à la ligne de bus de données, étant présent dans la partie de recouvrement,
un point nodal T assigné à la ligne d'alimentation, notamment à la ligne de courant triphasé, de même qu'un point nodal T assigné à une ligne de bus de données, étant présents dans la partie de connexion,
sachant que soit le point nodal T de la partie de recouvrement, soit le point nodal T assigné à la ligne de bus de données de la partie de connexion, est connecté électriquement, au moyen du commutateur, à la partie du circuit électronique conçue en tant qu'abonné au bus.

2. Agencement de convertisseur selon la revendication 1,
**caractérisé par le fait que**
la partie de recouvrement est munie d'une deuxième pièce de connexion enfichable dévolue au raccordement d'une ligne supplémentaire de bus de données, notamment au raccordement d'une pièce additionnelle correspondante de connexion enfichable complémentaire, façonnée au niveau d'une région extrême d'une ligne supplémentaire de bus de données,
les contacts de la première pièce de connexion enfichable étant connectés électriquement aux contacts de ladite deuxième pièce de connexion enfichable.

3. Agencement de convertisseur selon au moins l'une des revendications précédentes,
**caractérisé par le fait que**
la ligne de courant triphasé et la ligne de bus de données sont acheminées vers ledit agencement de convertisseur en tant que câble hybride, ou de manière distincte.

4. Agencement de convertisseur selon au moins l'une des revendications précédentes,
**caractérisé par le fait**
**qu'**une partie de contact respective du dispositif de raccordement est connectée électriquement à deux, ou plus de deux parties de contact de la troisième pièce de connexion enfichable, en vue d'alimenter le circuit électronique, en particulier de façon telle que ledit circuit électronique soit alimenté par l'intermédiaire de plusieurs contacts de la pièce correspondante de connexion enfichable complémentaire de la partie de recouvrement.

5. Agencement de convertisseur selon au moins l'une des revendications précédentes,
**caractérisé par le fait que**
la partie de connexion est dotée d'une seconde pièce formant douille, en vue du raccordement d'une ligne supplémentaire de bus de données,
les contacts de la première pièce formant douille étant connectés électriquement aux contacts de ladite seconde pièce formant douille.

6. Agencement de convertisseur selon au moins l'une des revendications précédentes,
**caractérisé par le fait que**
la partie de connexion est pourvue d'un dispositif supplémentaire de raccordement dévolu à une ligne supplémentaire de courant triphasé, les contacts dudit dispositif supplémentaire de raccordement étant connectés électriquement aux contacts du premier dispositif de raccordement.

7. Agencement de convertisseur selon au moins l'une des revendications précédentes,
**caractérisé par le fait que**
les première et seconde pièces formant douilles sont closes par un capuchon obturateur, de manière étanche, c'est-à-dire avec mode de protection élevé.

8. Agencement de convertisseur selon au moins l'une des revendications précédentes,
**caractérisé par le fait**
**qu'**un moyen affecté à la détermination d'une convolution discrète, sur la base d'une succession de bits reçue et sur la base d'une succession de bits stockée dans une mémoire de la partie de recouvrement, est intégré dans ladite partie de recouvrement, notamment dans le circuit électronique de ladite partie de recouvrement.

9. Agencement de convertisseur selon au moins l'une des revendications précédentes,
**caractérisé par le fait**
**qu'**un moyen de sélection est intégré dans la partie de recouvrement et engendre le signal de pilotage destiné au commutateur, notamment en fonction de la reconnaissance d'une succession de bits reçue,
sachant, en particulier, que ledit moyen de sélection maintient le commutateur en mode de fonctionnement alternatif aussi longtemps que la succession de bits n'est pas reconnue, et maintient ledit commutateur en mode de fonctionnement continu après que ladite succession de bits a été reconnue,
sachant notamment que ledit moyen de sélection est muni du moyen affecté à la détermination d'une convolution discrète.

10. Agencement de convertisseur selon au moins l'une des revendications précédentes,
**caractérisé par le fait que**
le moyen de sélection détermine et/ou engendre un signal affecté à la synchronisation temporelle, notamment en fonction de la reconnaissance d'une succession de bits reçue.

11. Procédé d'exploitation d'un agencement de convertisseur conforme à au moins l'une des revendications précédentes,
**caractérisé par le fait que**,
lors d'une première étape opératoire, en particulier au début du fonctionnement de l'agencement de convertisseur, le commutateur est actionné dans le premier ou le second état de commutation, en mode alterné, jusqu'à ce qu'un signal de bus, notamment une succession de bits émise par un maître de bus, sous la forme d'un télégramme diffusé en particulier, soit reconnu(e) dans l'un des deux états de commutation,
lors d'une seconde étape opératoire, ledit commutateur est ensuite maintenu durablement dans l'état de commutation dans lequel ladite succession de bits a été reconnue, notamment en vue du mode de fonctionnement continu dudit agencement de convertisseur.

12. Procédé selon la revendication 11,
**caractérisé par le fait que**,
pour reconnaître le signal de bus,
l'on détermine, relativement à un paramètre, le maximum d'une convolution discrète qui est formée en tant que convolution discrète d'une succession de bits reçue, notamment détectée, et d'une succession de bits connue déphasée de la valeur dudit paramètre, c'est-à-dire notamment stockée dans une mémoire.

13. Procédé selon la revendication 12,
**caractérisé par le fait que**
le paramètre ressortissant au maximum est utilisé pour la synchronisation temporelle.

14. Procédé selon la revendication 13 ou 12,
**caractérisé par le fait que**
le paramètre ressortissant au maximum est utilisé, pour la synchronisation temporelle, uniquement lorsque ledit maximum excède une valeur de seuil préétablie.
